Europäisches Patentamt

European Patent Office

Office européen des brevets

(11) Publication number: **0 109 692**
**A1**

## EUROPEAN PATENT APPLICATION

(21) Application number: **83111674.4**

(22) Date of filing: **22.11.83**

(51) Int. Cl.³: **H 01 L 29/08**
**H 01 L 29/78**

(30) Priority: **22.11.82 JP 204792/82**

(43) Date of publication of application:
**30.05.84 Bulletin 84/22**

(84) Designated Contracting States:
**DE FR GB**

(71) Applicant: **NISSAN MOTOR COMPANY, LIMITED**
**No.2, Takara-cho, Kanagawa-ku**
**Yokohama-shi Kanagawa-ken 221(JP)**

(72) Inventor: **Murakami, Koichi**
**13-10, Iwato 5-chome**
**Yokosuka-shi Kanagawa-ken(JP)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) Semiconductor device for a MOSFET.

(57) A semiconductor device for a lateral type MOSFET which can withstand a surge and prevent being broken. The device comprises a semiconductor wafer (21), diffused source (22) and drain (23) regions which the conductivity type thereof is different from that of the wafer, and a layer (24) of same conductivity type as the wafer formed along the bottom surface of the diffused drain region (23).

FIG.3

EP 0 109 692 A1

TITLE OF THE INVENTION

Semiconductor device for a MOSFET

BACKGROUND OF THE INVENTION

The present invention relates to a semiconductor device for a MOSFET (Metal-Oxide-Semiconductor Field-Effect Transistor), and more particularly to a so called "lateral type MOSFET" improved so as to prevent an element constituting the transistor from being broken due to breakdown.

There has been known conventional lateral type MOSFETs, for examples which are described in U.S. Pat. No. 4,370,798 and No. 4,384,301.

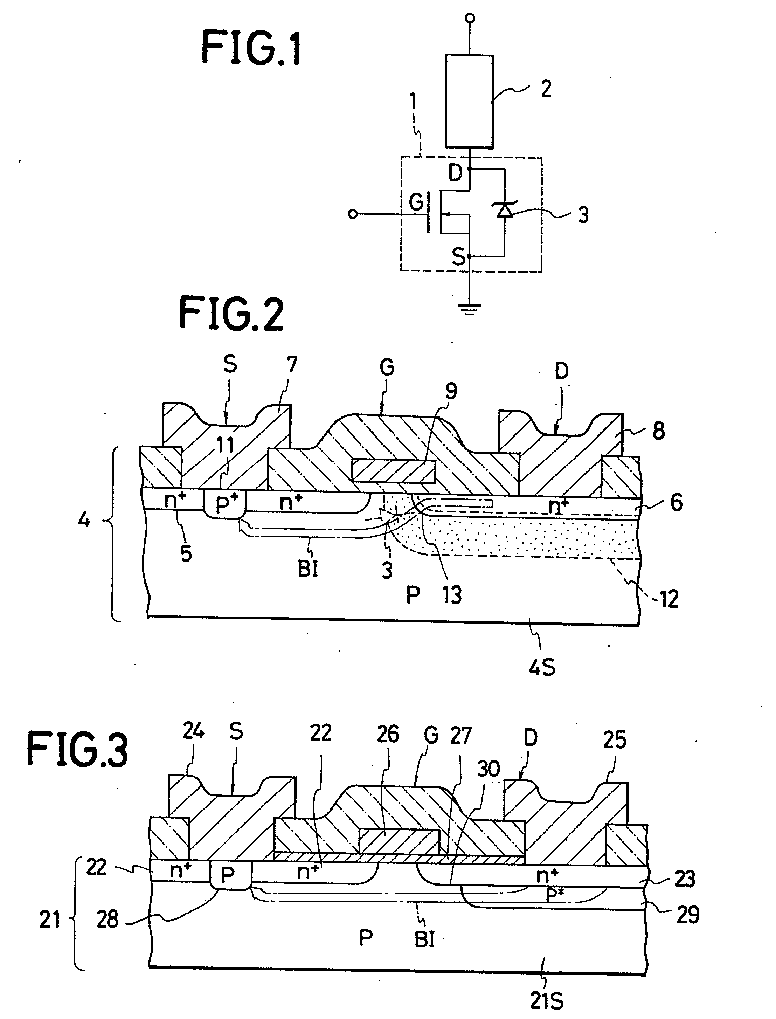

Recently, power MOSFETs have been increasingly developed. For instance, as shown in Fig. 1 a MOSFET 1 (which will be referred to solely "MOS transistor" hereinafter) is usually utlized as a switching element for a power load 2. Specifically, in the filed of vehicles, it has been proposed that the MOS transistors are applied to switching for various kinds of power loads embarked thereon.

An example of cell or chip structure of conventional n-channel MOS transistors is illustrated in Fig. 2. The MOS transistor shown is generally called "lateral type MOS transistor". The term "lateral type" is derived from the fact that currents flow in the horizontal or lateral direction of the transistor cell. A wafer 4 constituting the major portion of the transistor cell comprises a semiconductor substrate 4S of P-type conductivity. The wafer 4 includes a diffused source region 5 of $n^+$ type conductivity and a diffused drain region 6 of n+ type conductivity formed on the side of one principal or major surface of the wafer 4. The MOS transistor cell further comprises a source electrode 7 and a drain electrode 8 made of aluminum, which are formed on the upper surface of the wafer 4, and a gate electrode 9 interposed between the source electrode 7 and the drain electrode 8.

The wafer 4 further includes a wafer contact region 11 of $P^+$ type conductivity formed below the source electrode 7 serving as a common electrode in respect to a source S and the wafer 4.

The MOS transistor thus formed is constituted so as to improve withstand voltage, because it is necessary to effect relatively large voltage and current switching.

However, with the conventional MOS transistor, when the power load 2 is, for instance, an inductive load, such as, an electric motor or a solenoid, there occurs a surge when load currents are interrupted. As a result, because the element cannot withstand the surge, there is possibility that undesirable breakdown is caused.

This results from the fact that a parasitic Zener diode existing between the source S and the drain D, which originates from the structure of the MOS transistor 1, has not ability sufficient to withstand such a surge.

Reference is now made to the reason for the occurrence of the breakdown with reference to Fig. 2.

When a surge is applied between the drain D and the source S, there occurs a depletion layer 12 along the junction between the drain diffused region 6 and the substrate 4S. There is a tendency that an electric field applied to the depletion layer 12 is concentrated on a portion at which curvature of radius is small.

In this instance, the conventional MOS transistor illustrated in Fig. 2 has a portion (which will be called "edge portion" hereinafter) with relatively small curvature of radius at or along a bottom periphery of the diffused drain region 6. For this reason, it is likely that the above-described electric field is concentrated on the edge portion, particularly on the edge portion 13 located on the side of the gate G.

Accordingly, in the event that there occurs breakdown, breakdown currents labelled by BI collectively flow within a narrow area of the edge portion 13. As a result, there occurs heat concentration so that the element is broken.

SUMMARY OF THE INVENTION

With the above in mind, an object of the present invention is to provide a semiconductor device for a MOSFET, wherein the MOS transistor device is constituted so that the provision of a layer of a first conductivity type on the side of the drain makes it possible to prevent the occurrence of heat concentration, thereby preventing the transistor element from being broken, even if there occurs breakdown.

Another object of the present invention is to provide a semiconductor device for a MOSFET, wherein the MOS transistor device is constituted so that the provision of a second layer of a first conductivity type on the side of the source makes it possible to reduce wafer resistance, thereby preventing latch-up, for instance, paticularly when the MOS device of the invention is applied to a C-MOS device.

A further object of the invention is to provide a semiconductor device for a MOSFET, wherein the MOS transistor device is constituted so that the provision of an elongated modified second layer of a first conductively type close to the side surface of a diffused source region makes it possible to prevent punch-through to lower impurity concentration and improve withstand voltage, channel mobility and switching speed.

BRIEF DESCRIPTION OF THE DRAWINGS

These and other features and advantages of a semiconductor device for a MOSFET according to the present invention will become more apparent from the description in conjunction with the accompanying drawings, in which:

Fig. 1 is a switching circuit diagram in which a MOS transistor is employed,

Fig. 2 is a cross sectional view showing element structure of the prior art MOS transistor,

Fig. 3 is a cross sectional view illustrating a first embodiment of element structure according to the present invention,

Figs. 4(a) to 4(g) are views schematically illustrating fabricating steps of the MOS transistor shown in Fig. 3, respectively,

Fig. 5 is a cross sectional view illustrating a second embodiment of element structure according to the present invention,

Fig. 6 is a cross sectional view illustrating a third embodiment of element structure according to the present invention, and

Figs. 7(a) to 7(g) are views schematically illustrating fabricating steps of the MOS transistor shown in Fig. 6, respectively.

DETAILED DESCRIPTION OF PREFERRED EMBODIMENTS

Preferred embodiments according to the present invention will be described in detail in conjunction with accompanying drawings Figs. 3 to 7.

Referring to Fig. 3, there is shown an embodiment (which will be called "first embodiment" hereinafter) of the cell structure of a semiconductor device for a MOS transistor according to the present invention.

As seen from Fig. 3, a wafer constituting the major portion of the transistor cell comprises a P-type (which will be called "first conductivity type" hereinafter) semiconductor substrate 21S. The wafer 21 includes a diffused source region 22 of $n^+$ type conductivity and a diffused drain region 23 of $n^+$ type conductivity formed on a principal or major surface of the wafer 21, a source electrode 24 and a drain electrode 25 both of which are made of aluminum, and a gate electrode 26 insulated by an oxide film 27 and provided between the source electrode 24 and the drain electrode 25. The wafer 21 further includes a wafer contact region 28 formed below the source electrode 24 serving as a common electrode with respect to the source S and the wafer 21. In connecting with the parts or components stated above, the MOS transistor of the invention has the same structure as that of the prior art lateral n-channel MOS transistor illustrated in Fig. 2.

The MOS transistor according to this embodiment is featured as follows: The wafer 21 further includes a layer 29 of a first type conductivity (which will be called "$P^*$ type layer" hereinafter). More particularly, the $P^*$ type layer 29 is formed close to the bottom surface of the diffused drain region 23 in a manner to be stacked thereto. In this instance, the $P^*$ type layer 29 is the same P type as that of the wafer 21, and has concentration higher than that of the wafer 21. However, the concentration of the $P^*$ type layer 29 is lower than that of the wafer contact region 28. Accordingly, the $P^*$ type layer 29 referring to the layer of the first conductivity type is simbolized by $P^*$.

In the MOS transistor thus constructed, assuming that there occurs a surge from the power load 2, whereby a high voltage is applied between the source S and the drain D. In this instance, an electric field is concentrated on an edge portion 30 located on the side of the gate G in the diffused drain region 23.

However, since the $P^*$ type layer 29 is formed, there occurs breakdown at or along the junction surface between the $P^*$ type layer 29 and the diffused drain region 23, prior to occurence of breakdown at the edge portion 30. As a result, the breakdown current BI flows through a broad area in the bottom surface of the diffused drain region 23, thereby making it possible to prevent the occurence of heat concentration.

This results from the fact that the withstand voltage of the junction between the $P^*$ type layer 29 and the diffused drain region 23 is lower than that of the junction between the diffused drain region 23 and the substrate 21S. For instance, in the prior art MOS transistor without provision of the $P^*$ type layer, assuming that the withstand voltage of the junction between the diffused drain region 23 and the substrate 21S is 75 volts. Since the withstand voltage of the edge portion is of the order of 30 volts, when a surge is applied thereto, there occurs breakdown first at the edge portion whose withstand voltage is lower than others. However, the provision of the $P^*$ type layer 29 allows the withstand voltage of the junction between the diffused drain region 23 and the $P^*$ type layer 29 to be lowered approximately to 25 volts, which is lower than that of the withstand voltage of the edge portion 30. Accordingly, when a surge is applied thereto, there occurs first at the junction between the $P^*$ type layer 29 whose withstand voltage is lower than that of the edge portion 30. For this reason, there is no possibility that the breakdown currents BI flow in a broad area without being concentrated on a narrow area, such as, the edge portion 30. As a result, there occurs no heat concentration.

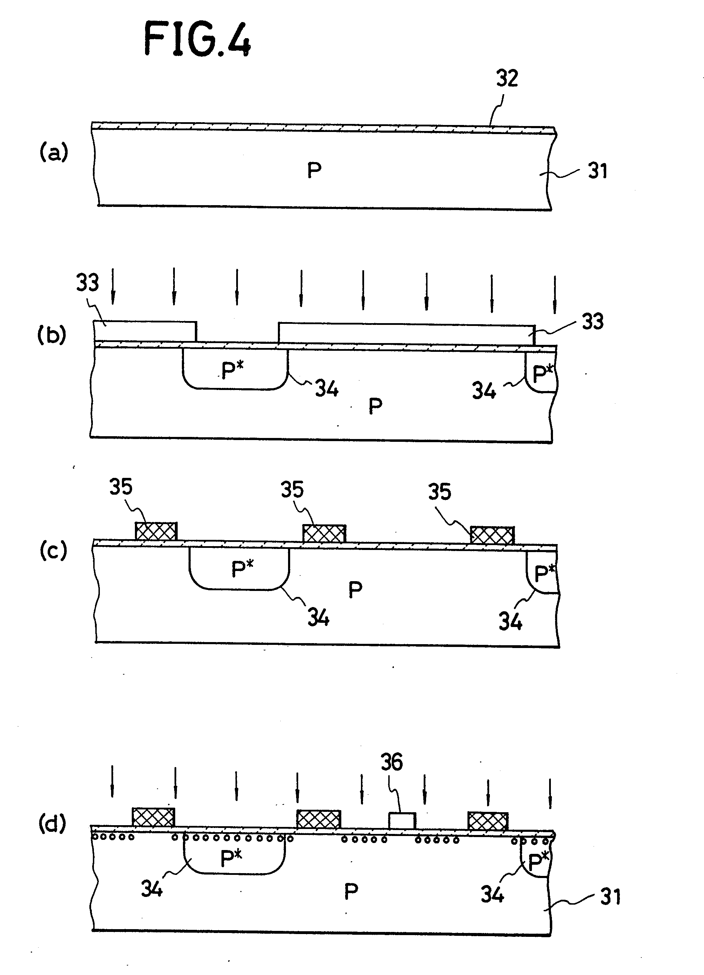

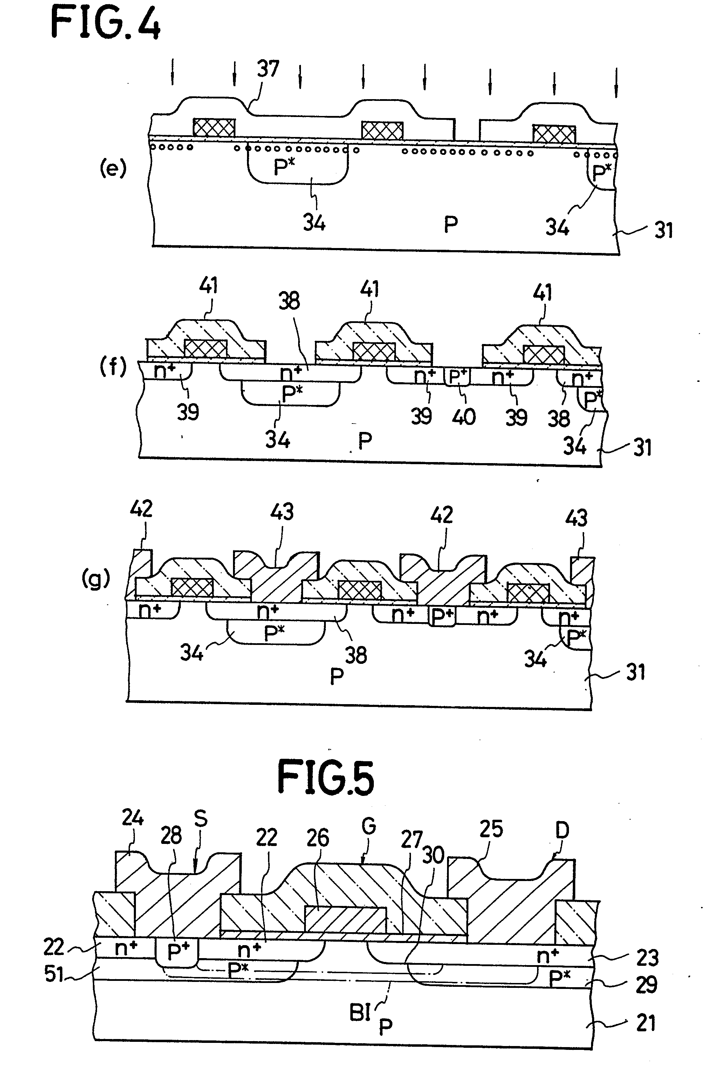

Reference is now made to the fabricating steps of the MOS transistor stated above in conjunction with Figs. 4(a) to 4(g).

Initially, as shown in Fig. 4(a), a method of fabricating the MOS transistor cell comprises the steps of forming a field oxide film (not shown) of $5 \times 10^{-2}$ nm (nano meter) to $1 \times 10^{-3}$ nm (5,000 A to 10,000 A) on one principal surface of a silicon wafer 31 of P-type conductivity, removing by photo-etching the field oxide film in a region where the element is formed, and forming a gate oxide film 32 on this surface.

As shown in Fig. 4(b), the method further comprises the steps of masking portions except for a drain region with a resist 33, effecting an implantation of boron ion solely at the bottom portion of the drain region, and diffusing the boron thereinto to form a layer 34 of $P^*$ type conductivity.

As shown in Fig. 4(c), the method further comprises the steps of forming a polysilicon layer onto the whole surface by CVD (Chemical Vapour Deposition ), and effecting photo-etching to remove the polysilicon layer except for portions corresponding to a gate electrodes 35.

As shown in Fig. 4(d), the method further comprises the steps of providing a resist 36 on a wafer contact region, and effecting injection of phosphorus ion into a source region and a drain region.

As shown in Fig. 4(e), the method further comprises the steps of masking the portion except for the wafer contact region with a resist 37, and effecting injection of boron ion into the wafer contact region.

As shown in Fig. 4(f), the method further comprises the steps of forming the source and drain region 38, 39 of $n^+$ type conductivity, and the wafer contact region 40 of $P^+$ type conductivity by diffusion, forming a PSG (Phospho-silicate glass) layer 41 on the whole surface thereof, and removing solely the PSG layer 41 corresponding to the source and drain regions by photo-etching.

Finally, as shown in Fig. 4(g), the method further comprises the step of forming a source electrode 42 and a drain electrode 43 by coating each region with aluminum.

In respect of the above-mentioned fabricating steps, care must be taken to the following points: Firstly the $P^*$ type layer 34 does not reach the edge portion of the diffused drain region 38. Secondly it is necessary to control the impurity concentration of $P^*$ type layer 34 so that the withstand voltage of the junction between the $P^*$ type layer 34 and the diffused drain region 38 is lower than that of the junction between the edge portion of the drain region 38 and the wafer 31.

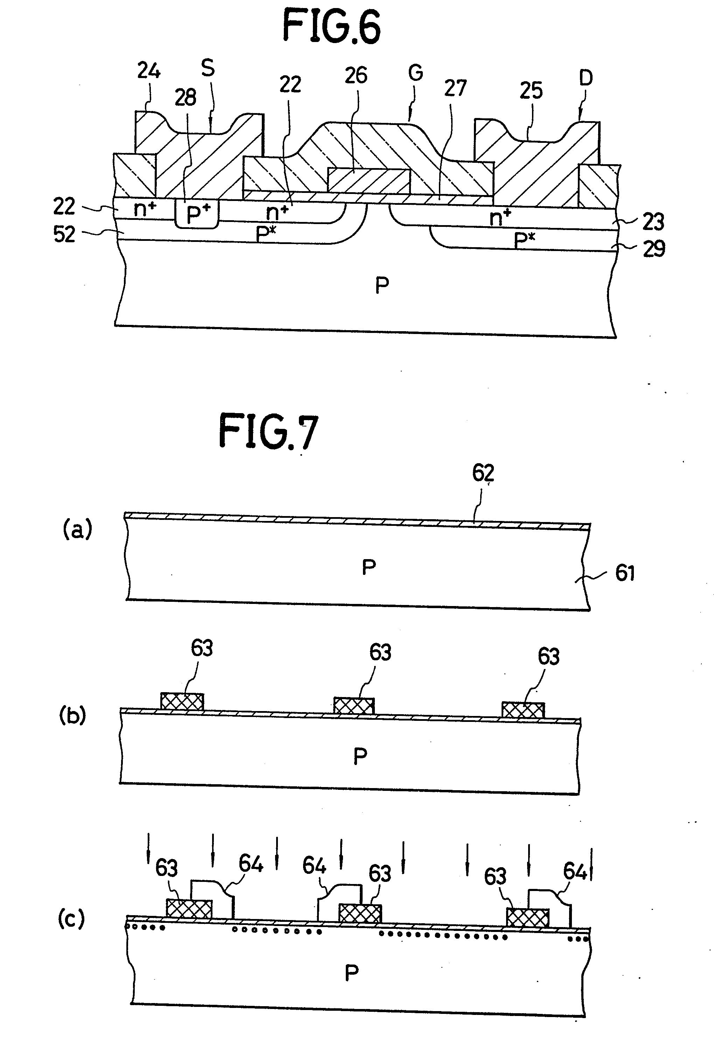

Referring to Fig. 5, there is shown a MOS transistor cell of the second embodiment according to the present invention. Like reference numerals designate the components identical or similar to those shown in Fig. 3.

The MOS transistor cell according to the second embodiment is characterized in that in addition to the structure of the MOS transistor cell according to the first embodiment, a second layer 51 of $P^*$ type conductivity, similar to the $P^*$ type layer 29 provided on the side of the diffused drain region 23, is formed to be stacked to the lower or bottom surfaces of the diffused source region 22 and the wafer contact region 28 and to be in contact therewith.

The provision of the second layer 51 of $P^*$ type conductivity makes it possible to reduce wafer resistance. Particularly, when the MOS transistor thus formed is applied to a C-MOS transistor (Complementary MOS transistor), it is possible to prevent latch-up when forming this element in a P-well.

The MOS transistor cell of the second embodiment can be fabricated with a method similar to that of the first embodiment shown in Figs. 4(a) to 4(g). In the step shown in Fig. 4(b), when implantation of boron ion to the drain region is effected, it is sufficient to effect implantation of boron ion into the source region at the same time.

Referring to Fig. 6, there is shown a MOS transistor of the third embodiment according to the present invention. Similar to the second embodiment, a third layer of $P^*$ type conductivity is formed to be stacked and close to the both lower or bottom surfaces of the diffused source region 22 and the wafer contact region 28. The MOS transistor of the third embodiment is characterized in that the third $P^*$ type layer 52 has an elongated end portion stacked to the side surface of the diffused source region 22 positioned on the side of the gate G and in contact therewith, resulting in one end of the third $P^*$ type layer 52 being exposed to the surface of the wafer 21.

The above structual feature is achieved by forming the diffused source region 22 and the third $P^*$ type layer 52 with a DSA (Diffusion Self Aligned) method.

As stated above, the provision of the third elongated $P^*$ type layer 52 makes it possible to prevent punch-through which originate from the fact that a depletion layer produced on the side of the diffused drain region 23 reaches the diffused source region 22. Thus, this enables to lower the impurity concentraton of the wafer 21 and increase the withstand voltage thereof. Further, this makes it possible to enhance the channel mobility and to lessen or reduce capacity, which determines a switching speed, between the gate and the wafer.

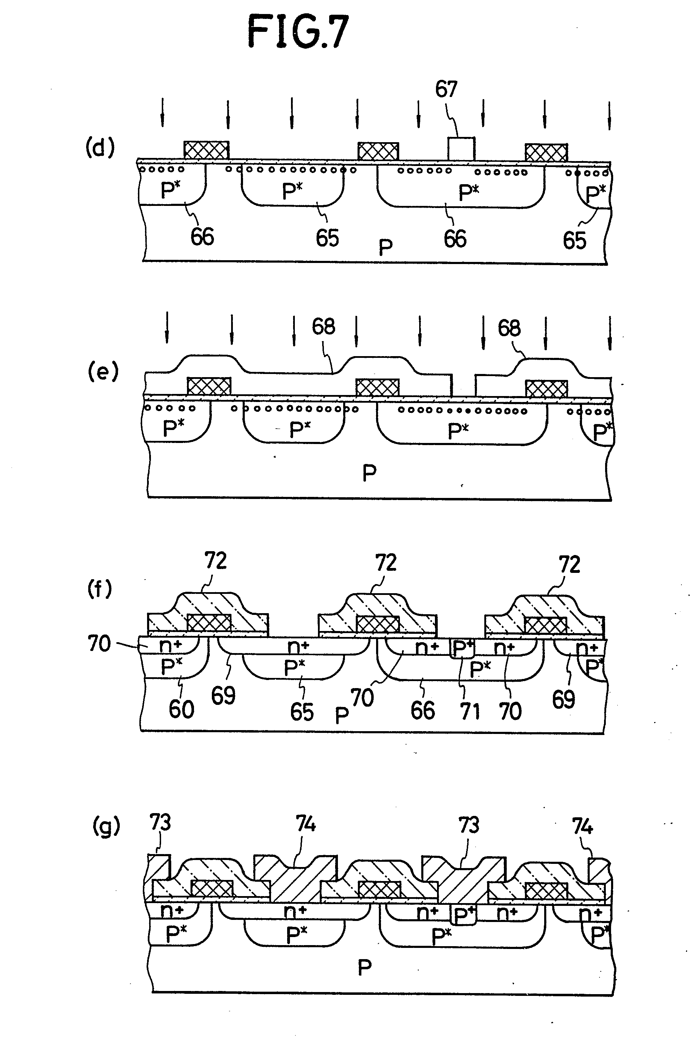

A method of fabricating the MOS transistor cell of the third embodiment will be described with reference to Figs. 7(a) to 7(g).

Initially, as shown in Fig. 7(a), the method comprises the steps of forming a field oxide film (not shown) having thickness of $5 \times 10^{-2}$ nm (nano meter) to $1 \times 10^{-3}$ nm (5,000 A to 10,000 A) on the side of a principal or major surface of a P-type silicon wafer 61, removing by photo-etching the field oxide film in a region where the element is formed, and forming a gate oxide film 62 on this surface.

As shown in Fig. 7(b), the method further comprises the steps of forming a polysilicon layer on the whole surface thereof, and effecting photo-etching to remove the polysilicon layer except for the portion corresponding to a gate electrode 63 by photo-etching.

As shown in Fig. 7(c), the method further comprises the step of effecting implantation of boron ion, on condition that the gate electrode 63 of polysilicon serves as a mask on the side of a source and a resist 64 serves as a mask on the side of a drain.

As shown in Fig. 7(d), the method comprises the steps of diffusing layers 65 and 66 of $P^*$ type conductivity, and effecting an implantation of phosphorus ion to regions except for the wafer contact region, under condition that the gate eletrode 63 of polysilicon and a resist 67 serve as a mask, respectively.

As shown in Fig. 7(e), the method further comprises the steps of masking a portion except for the wafer contact region with a resist 68, and effecting implantation of boron ion into the wafer contact region.

As shown in Fig. 7(f), the method further comprises the steps of diffusing regions 69 and 70 of $n^+$ type conductivity, and a region 71 of $P^+$ type conductivity, forming a PSG layer 72 serving as an intermediate film on the whole surface thereof, and removing the PSG layer 72 and the gate oxide film corresponsing to the source contact portion and the drain contact portion by photo-etching.

Finally, as shown in Fig. 7(g), the method further comprises the step of coating the source and drain regions with aluminum to form a source electrode 73 and a drain electrode 74.

In the embodiment described above, reference has been made to the n-channel lateral type MOS transistor. However, it is obvious that the present invention is applicable to a P-channel lateral type MOS transistor.

In the above-described embodiments, the most essential structure of the MOS transistor has been described. However, it is also clear that the present invention is applicable to the lateral type MOS transistor with a complicated structure, such as, gardring, field plate, or offset gate.

As described in detail, the MOS transistor according to the present invention is characterized in that in a lateral type MOS transistor, there is formed a layer of a first conductivity type which is formed to be stacked close to the bottom surface of the diffused drain region, and which has the same conductivity type as that of the wafer and concentration higher than that thereof. As a result, even if there occurs breakdown due to a surge being produced from a power load, breakdown currents caused thereby do not collectively flow within a localized portion. Accordingly, the breakdown current flows in a broad area along the junction between the diffused drain region and the layer of the first conductivity type. This makes it possible to prevent from occurence of heat concentration, whereby the element can be prevented from being broken. Thus, the MOS transistor which can withstand a surge is obtained.

Accordingly, when the MOS transistor of the invention is applied to, for instance, a switching element for power loads embarked on vehicles, the reliability of the element can be improved, thereby making it possible to improve performance and safety concerned with vehicle.

What is claimed is:

1. A semiconductor device for a lateral type MOSFET comprising;

a semiconductor wafer of a first conductivity type,

diffused source and drain regions formed on the side of a principal surface of said wafer,

said diffused source and drain regions each being of a conductivity type opposite that of said wafer, and

a first layer of said first conductivity type formed along the bottom surface of said diffused drain region to be stacked thereto and in contact therewith,

said first layer having concentration higher than that of said semiconductor wafer.

2. A semiconductor device according to claim 1, which further comprises a wafer contact region of said first conductivity type formed in said source region.

3. A semiconductor device according to claim 2, wherein said first layer has concentration lower than that of said wafer contact region.

4. A semiconductor device according to claim 1, wherein said semiconductor wafer further includes a second layer of said first conductivity type formed along the bottom surface of said diffused source region to be stacked thereto and in contact therewith, said second layer having concentration higher than that of said semiconductor wafer.

5. A semiconductor device according to claim 4, wherein said second layer of said first conductivity type is provided with an end portion elongated to be stacked to the side surface of said diffused source region and in contact therewith.

6. A semiconductor device according to claim 5, wherein said end portion of said second layer is exposed to the principal surface of said semioconductor wafer on which a gate electrode is provided.

7. A semiconductor device for a lateral type MOSFET comprising;

a semiconductor wafer of a first conductivity type, diffused source and drain regions formed on the side of a principal surface of said wafer, said diffused source and drain regions each being of a second conductivity type opposite that of said wafer, and a first layer of said first conductivity type formed along the bottom surface of said diffused source region in a manner to be stacked thereto and in contact therewith, said first layer having concentration higher than that of said semiconductor wafer.

8. A semiconductor device according to claim 7, which further comprises a wafer contact region of said first conductivity type formed in said source region.

9. A semiconductor device according to claim 8, wherein said first layer has concentration lower than that of said wafer contact region.

10. A semiconductor device according to claim 7, wherein said first layer of said first conductivity type is provided with an end portion elongated so as to be stacked to the side surface of said diffused source region and in contact therewith.

11. A semiconductor device according to claim 10, wherein said end portion of said first layer is exposed to the principal surface of said semioconductor wafer, on which a gate electrode is provided.

0109692

# FIG.1

2

1

G

D

S

3

# FIG.2

S   7   G   9   D

8

11

4

$n^+$   $P^+$   $n^+$   $n^+$   6

5   BI   3   P   13   12

4S

# FIG.3

24   S   22   26   G   27   D   25

30

22

$n^+$   P   $n^+$   $n^+$   23

21   28   $P^*$   29

P   BI

21S

FIG.4

# FIG.4

(e)

(f)

(g)

# FIG.5

0109692

## FIG.6

## FIG.7

FIG.7

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | EP-A-0 023 528  (MOSTEK CORP.)<br><br>* claims 1-20; figure 22 *<br><br>--- | 1,4,5, 7 | H 01 L   29/08<br>H 01 L   29/78 |
| A | EP-A-0 003 231  (SIEMENS AG)<br>* claims 1-12; figure 6 *<br><br>--- | 1,7 | |
| A | GB-A-2 011 178  (PHILIPS ELECTRONIC AND ASSOCIATED INDUSTRIES LTD)<br><br>--- | | |
| A | FR-A-2 464 536  (TEXAS INSTRUMENTS INC.)<br><br>----- | | |

**TECHNICAL FIELDS SEARCHED (Int. Cl. ³)**

H 01 L

The present search report has been drawn up for all claims

| Place of search | Date of completion of the search | Examiner |
|---|---|---|
| THE HAGUE | 13-02-1984 | ZOLLFRANK G.O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82